(19) Europäisches Patentamt
European Patent Office
Office européen des brevets

(11) EP 4 503 435 A1

(12) EUROPEAN PATENT APPLICATION
published in accordance with Art. 153(4) EPC

(43) Date of publication:
05.02.2025 Bulletin 2025/06

(51) International Patent Classification (IPC):
H03H 9/17 (2006.01)

(21) Application number: 23780682.3

(52) Cooperative Patent Classification (CPC):
H03H 9/17

(22) Date of filing: 29.03.2023

(86) International application number:
PCT/JP2023/012773

(87) International publication number:
WO 2023/190673 (05.10.2023 Gazette 2023/40)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 31.03.2022 JP 2022058815

(71) Applicant: Nitto Denko Corporation
Ibaraki-shi, Osaka 567-8680 (JP)

(72) Inventors:
• AOKI, Yuzuki
Ibaraki-shi, Osaka 567-8680 (JP)
• NAKAMURA, Daisuke
Ibaraki-shi, Osaka 567-8680 (JP)
• MACHINAGA, Hironobu
Ibaraki-shi, Osaka 567-8680 (JP)

(74) Representative: Müller-Boré & Partner
Patentanwälte PartG mbB
Friedenheimer Brücke 21
80639 München (DE)

(54) BULK ELASTIC WAVE FILTER DEVICE

(57) Bulk acoustic wave filter device having good heat dissipation property is provided. Bulk acoustic wave filter device includes: acoustic multilayer film on support substrate, first layer having predetermined specific acoustic impedance and second layer having specific acoustic impedance lower than that of first layer being alternately laminated in acoustic multilayer film; and active element provided on a side of acoustic multilayer film opposite to support substrate. Active element includes first electrode layer provided over acoustic multilayer film, piezoelectric layer provided on first electrode layer, and second electrode layer provided on piezoelectric layer. Part or whole of acoustic multilayer film has electrical conductivity. Insulating layer is provided between acoustic multilayer film and first electrode layer. In a preferred configuration example, second layer having electrical conductivity has electrical resistivity of $1.0 \times 10^{-3}$ S2cm or lower.

FIG.2

**Description**

TECHNICAL FIELD

The present invention relates to a bulk acoustic wave filter device.

BACKGROUND ART

Use of high-frequency radio waves such as microwaves, millimeter waves, and terahertz waves enables high-speed broadband communications. According to the 5G mobile communication standard, a frequency band close to 6 GHz, referred to as "sub-6", and the 28 GHz-band are used, and future use of the 100 GHz-band is also studied. Thus, resonators and band-pass filters suited to high frequencies exceeding some gigahertz are demanded. For resonators of electronic devices such as smartphones and the like, and high-frequency filters of communication devices, BAW resonators utilizing Bulk Acoustic Waves (BAW) or BAW filters are used. The thickness of a functional layer that is a constituent of a BAW device is determined by the intended frequency, and the higher the frequency, the thinner, the layer. Since a functional element (or an active element) included in a BAW resonator and the like undergoes acoustic property or electrical property changes due to heat, a configuration that can be less affected by heat is required.

In a known configuration, an acoustic mirror layer, in which a low heat-conductive layer and a high heat-conductive layer are laminated alternately, is provided between a resonator and a support substrate, such that the resonator and the support substrate are joined via a heat bridge (for example, see PTL 1).

CITATION LIST

PATENT LITERATURE

PTL 1: Japanese Patent No. 6668347

SUMMARY OF THE INVENTION

TECHNICAL PROBLEM

Elements are being increasingly miniaturized along with increasing demand on electronic and communication devices for adaptation to higher frequencies, and degradation of device functions due to temperature rise during driving of devices is becoming a problem. The publicly-known configuration provided with the heat bridge may require complicated processing steps for forming the heat bridge. A configuration in which an acoustic mirror is surrounded sideways by a heat bridge cannot obtain an efficient heat dissipation property because a heat conduction pass occurs across a low heat-conductive layer. A configuration in which a heat bridge is provided immediately under a resonator has a low resonating property because the heat bridge becomes an obstacle against acoustic wave reflection by an acoustic mirror.

According to one aspect, it is an object of the present invention to provide a bulk acoustic wave filter device having a good heat dissipation property.

SOLUTION TO THE PROBLEM

In an embodiment, a bulk acoustic wave filter device includes:

an acoustic multilayer film on a support substrate, a first layer having a predetermined specific acoustic impedance and a second layer having a specific acoustic impedance lower than that of the first layer being alternately laminated in the acoustic multilayer film; and

an active element provided on a side of the acoustic multilayer film opposite to the support substrate, wherein the active element includes a first electrode layer provided over the acoustic multilayer film, a piezoelectric layer provided on the first electrode layer, and a second electrode layer provided on the piezoelectric layer,

one or more, or all of second layers, each being the second layer, in the acoustic multilayer film have an electrical conductivity, and

an insulating layer is provided between the acoustic multilayer film and the first electrode layer.

In a preferred configuration example, the second layer that has the electrical conductivity has an electrical resistivity of $1.0 \times 10^{-3}$ S2cm or lower.

ADVANTAGEOUS EFFECTS OF THE INVENTION

A laminate having a good heat dissipation property, and a high-frequency filter device using this are realized.

BRIEF DESCRIPTION OF THE DRAWINGS

[FIG. 1] FIG. 1 is an exemplary view of a laminate used in a bulk acoustic wave filter device according to an embodiment.
[FIG. 2] FIG. 2 is an exemplary view of a bulk acoustic wave filter device using the laminate of FIG. 1.
[FIG. 3] FIG. 3 is an exemplary view of a modified example of the laminate of FIG. 1.
[FIG. 4] FIG. 4 is an exemplary view of a bulk acoustic wave filter device using the laminate of FIG. 3.
[FIG. 5A] FIG. 5A is a diagram indicating the configuration and thermal properties of laminates of Examples.

[FIG. 5B] FIG. 5B is a diagram indicating the configuration and thermal properties of laminates of Examples.

[FIG. 5C] FIG. 5C is a diagram indicating the configuration and thermal properties of laminates of Comparative Examples.

DETAILED DESCRIPTION OF THE INVENTION

Heat conduction through thin films mainly encompasses heat conduction by phonons (lattice vibration) and heat conduction by carriers. Silicon oxide films ($SiO_2$) that have been used as low-acoustic-impedance layers of acoustic mirrors so far are insulating materials, and conduct heat predominantly by phonons. In general, heat conduction by carriers is more efficient than heat conduction by phonons, because the mean free path of carriers is long. Heat conduction by carriers is affected by the carrier density, whereas heat conduction by phonons is not directly affected by the carrier density. Thus, in an embodiment, predominant heat conduction by carriers is explored to improve the heat dissipation effect of a functional device utilizing vibration.

In the following, a specific configuration of a bulk acoustic wave filter device according to an embodiment will be described with reference to the drawings. The embodiment specified below is an example for realizing the technical idea of the present disclosure, and is not meant to limit the content of the disclosure. The size, positional relationship, and the like of the constituent elements illustrated in the drawings may be exaggerated in order to facilitate understanding of the invention. The same constituent elements or functions may be referred to by the same names or denoted by the same reference signs, and duplicate descriptions may be omitted to the extent possible. A positional relationship that is described by "above", "over", "on", "in an upper portion", and the like, or "under", "in a lower portion", and the like means a level relationship in the layer lamination direction or the film forming direction, and not in an absolute direction, unless otherwise particularly specified.

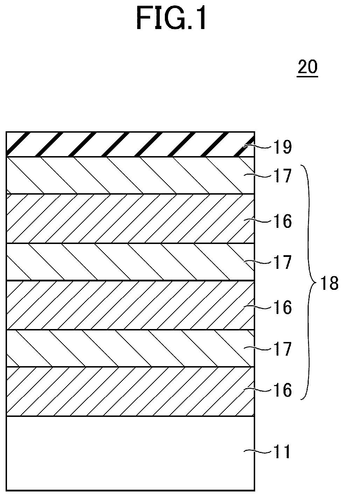

FIG. 1 is an exemplary view of a laminate 20 used in a bulk acoustic wave filter device according to an embodiment. The laminate 20 includes over a support substrate 11, an acoustic multilayer film 18 and an insulating layer 19 provided on the acoustic multilayer film 18. The acoustic multilayer film 18 is a multilayer film in which a first layer 16 having a predetermined specific acoustic impedance and a second layer 17 having a specific acoustic impedance lower than that of the first layer are alternately laminated such that the acoustic multilayer film 18 has two pairs or more of the first layer 16 and the second layer 17. As the first layer 16 has a specific acoustic impedance higher than that of the second layer 17, for the sake of expediency, the first layer is referred to as the "high-acoustic-impedance layer 16", and the second layer is referred to as the "low-acoustic-impedance layer 17". The embodiment is characterized by at least one low-acoustic-impedance layer 17 being made of an electrically-conductive oxide.

When a resonant vibration is transmitted to the acoustic multilayer film 18 through the insulating layer 19, the resonant vibration energy is reflected by the acoustic multilayer film 18. The speed at which the waves (acoustic waves) of the vibration propagate the high-acoustic-impedance layer 16 and at which they propagate the low-acoustic-impedance layer 17 are different. With a film thickness design that facilitates interference and mutual enhancement of reflected waves at the interfaces of the layers constituting the acoustic multilayer film 18, the resonant vibration energy is caused to return in the direction to where the acoustic waves are incident without being affected by the support substrate 11, while heat energy is caused to dissipate in the direction to the support substrate 11.

The high-acoustic-impedance layer 16 is made of a material having a high density or bulk modulus, such as tungsten (W), molybdenum (Mo), tantalum oxide ($Ta_2O_5$), zinc oxide (ZnO), or the like. The low-acoustic-impedance layer 17 is made of a material having a density or bulk modulus lower than that of the high-acoustic-impedance layer 16, and selection of a material having an electrical conductivity realizes heat conduction by carriers. The range of the material's electrical resistivity is preferably $1.0 \times 10^{-3}$ S2cm or lower, more preferably $8.0 \times 10^{-4}$ S2cm or lower, and yet more preferably $5.0 \times 10^{-4}$ S2cm or lower. In the following description, "electrical resistivity" may simply be referred to as "resistivity".

As the low-acoustic-impedance layer 17, an electrically-conductive oxide such as indium tin oxide (ITO), Al-doped zinc oxide (AZO), In-doped zinc oxide (IZO), fluorine-doped tin oxide (FTO), Ga-doped zinc oxide (GZO), antimony-doped tin oxide (ATO), phosphorus-doped tin oxide (PTO), and the like is used. In general, these materials are used as transparent electrically-conductive films. As described below, the heat conductivity of the low-acoustic-impedance layer 17 is 3 W/mK or higher, and more preferably 3.35 W/mK or higher. The low-acoustic-impedance layer 17 may be an amorphous layer or a mainly amorphous layer. The low-acoustic-impedance layer 17 being a mainly amorphous layer can inhibit increase of stress in the high-acoustic-impedance layer 16.

The high-acoustic-impedance layer 16 and the low-acoustic-impedance layer 17 are formed over support substrate 11 by sputtering or the like. Use of an electrically-conductive oxide as the low-acoustic-impedance layer 17 can realize heat diffusion by carriers, eliminating the need for complicated processing steps for providing a heat bridge or the like.

The support substrate 11 is a desirably selected substrate that can support the acoustic multilayer film 18. A semiconductor substrate such as silicon (Si) and the like, or an inorganic dielectric substrate such as MgO, sapphire, and the like, or a plastic substrate may be used.

When using a flexible substrate as the support substrate 11, polyethylene terephthalate (PET), polyethylene naphthalate (PEN), polycarbonate (PC), acrylic-based resins, cycloolefin-based polymers, polyimide (PI), thin-film glass and the like may be used. The insulating layer 19 provided on a surface on a side opposite to the support substrate 11 electrically insulates the acoustic multilayer film 18 from an active element (a resonator or the like) connected to the acoustic multilayer film 18.

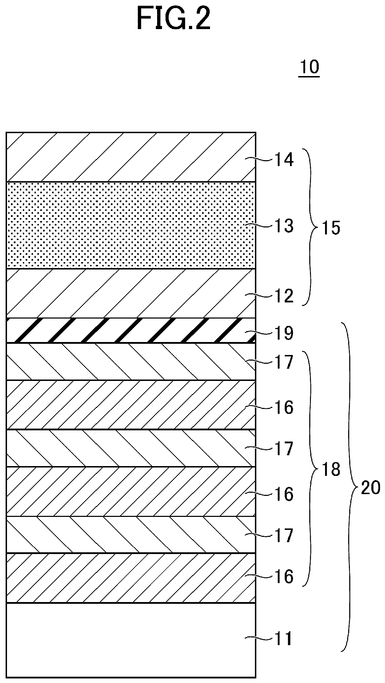

FIG. 2 is an exemplary view of a bulk acoustic wave filter device 10 using the laminate 20 of FIG. 1. The bulk acoustic wave filter device 10 includes, over the insulating layer 19 of the laminate 20, a first electrode layer 12, a second electrode layer 14, and a piezoelectric layer 13 provided between the first electrode layer 12 and the second electrode layer 14. The first electrode layer 12, the second electrode layer 14, and the piezoelectric layer 13 form a resonator 15, which is an active element.

The first electrode layer 12 and the second electrode layer 14 are made of an electrically-conductive material. For example, as the electrically-conductive material, Mo, W, Pr, Au, Ru, Ir, Al, Cu, and the like may be used. As the material of the piezoelectric layer 13, wurtzite crystals, perovskite crystals, and the like may be used. A predetermined amount of an impurity element may be added as a sub component to any of these types of crystal materials serving as a main component. As the wurtzite piezoelectric material, zinc oxide (ZnO), aluminum nitride (AlN), gallium nitride (GaN), and the like may be used.

When a high-frequency wave is input into the resonator 15, the resonator resonantly vibrates at a specific frequency corresponding to the film thickness of the piezoelectric layer 13. When the resonator 15 is driven, it generates a resonant vibration energy, and also generates heat through electrical driving. The resonant vibration energy transmitted to the acoustic multilayer film 18 through the insulating layer 19 is reflected by the acoustic multilayer film 18, thereby returning to the resonator 15 and becoming trapped between the first electrode layer 12 and the second electrode layer 14. The trapped vibration is extracted as an electrical signal via the first electrode layer 12 and the second electrode layer 14.

The heat generated by driving of the resonator 15 is conducted to the support substrate 11 side by the acoustic multilayer film 18. The low-acoustic-impedance layer 17 having a heat conductivity of 3 W/mK or higher can efficiently conduct heat to the support substrate 11 side.

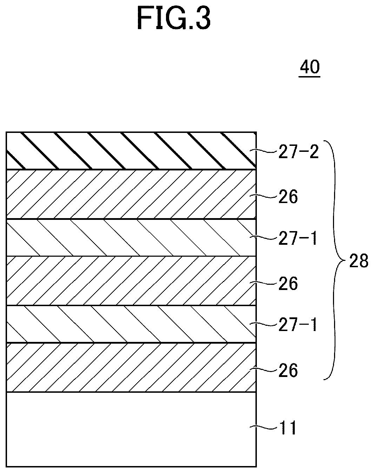

FIG. 3 is an exemplary view of a laminate 40, which is a modified example of the laminate 20 of FIG. 1. In the laminate 20 of FIG. 1, all low-acoustic-impedance layers 17 in the acoustic multilayer film 18 are made of an electrically-conductive oxide, and the insulating layer 19 is provided on the acoustic multilayer film 18. In the laminate 40 of FIG. 3, one or more low-acoustic-impedance layers are made of an electrically-conductive oxide, and another or more low-acoustic-impedance layers are made of an existing insulating material. At least a low-acoustic-impedance layer 27-2 that is provided as the uppermost layer of an acoustic multilayer film 28 is made of an insulating material. The insulating material is $SiO_2$, $Al_2O_3$, or the like.

The laminate 40 includes, on a support substrate 11, the acoustic multilayer film 28 in which a high-acoustic-impedance layer 26 and a low-acoustic-impedance layer 27-1 or 27-2 are laminated alternately. In the acoustic multilayer film 28, the low-acoustic-impedance layer 27-2 that is on the side opposite to the support substrate 11 to be connected to an active element such as a piezoelectric element, a resonator, or the like may be made of an insulating material, and the other low-acoustic-impedance layers 27-1 may be made of an electrically-conductive oxide. This configuration does not need to be provided with a particular insulating layer over the acoustic multilayer film 28. Since the occupation ratio of the insulating low-acoustic-impedance layer 27-2 in the acoustic multilayer film 28 is small, heat can be efficiently conducted to the support substrate 11 by the high-acoustic impedance layers 26 and the low-acoustic-impedance layers 27-1 made of an electrically-conductive oxide.

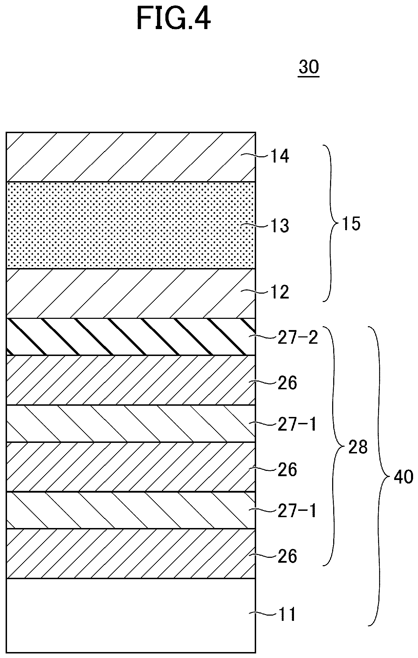

FIG. 4 is an exemplary view of a bulk acoustic wave filter device 30 using the laminate 40 of FIG. 3. The bulk acoustic wave filter device 30 includes, over the laminate 40, a first electrode layer 12, a second electrode layer 14, and a piezoelectric layer 13 provided between the first electrode layer 12 and the second electrode layer 14. The first electrode layer 12, the second electrode layer 14, and the piezoelectric layer 13 form a resonator 15, which is an active element.

The configuration of the resonator 15 is the same as that of the resonator 15 of FIG. 2. As the piezoelectric layer 13, a perovskite crystal or a wurtzite crystal may be used.

When a high-frequency wave is input into the resonator 15, the resonator resonantly vibrates at a specific frequency corresponding to the film thickness of the piezoelectric layer 13. When the resonator 15 is driven, it generates a resonant vibration energy, and also generates heat through electrical driving. The resonant vibration energy transmitted to the acoustic multilayer film 28 from the resonator 15 is reflected by the acoustic multilayer film 28, thereby returning to the resonator 15 and becoming trapped between the first electrode layer 12 and the second electrode layer 14. The trapped vibration is extracted as an electrical signal via the first electrode layer 12 and the second electrode layer 14.

The configurations of FIG. 3 and of FIG. 4 as well have a high heat dissipation effect, since at least one or more low-acoustic-impedance layers 28-1 of the low-acoustic-impedance layers included in the acoustic multilayer film 28 are made of an electrically-conductive oxide.

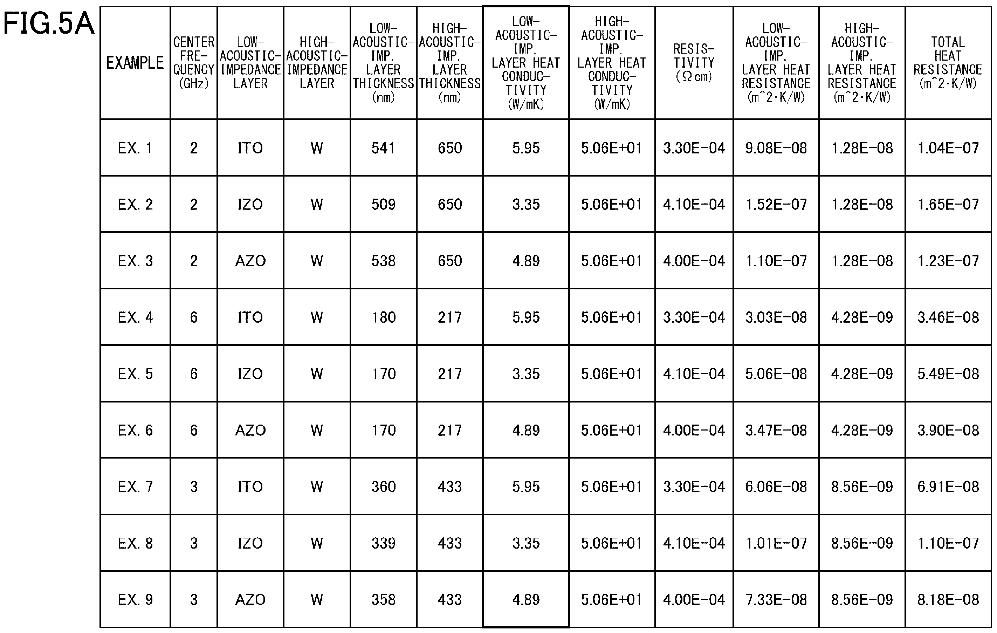

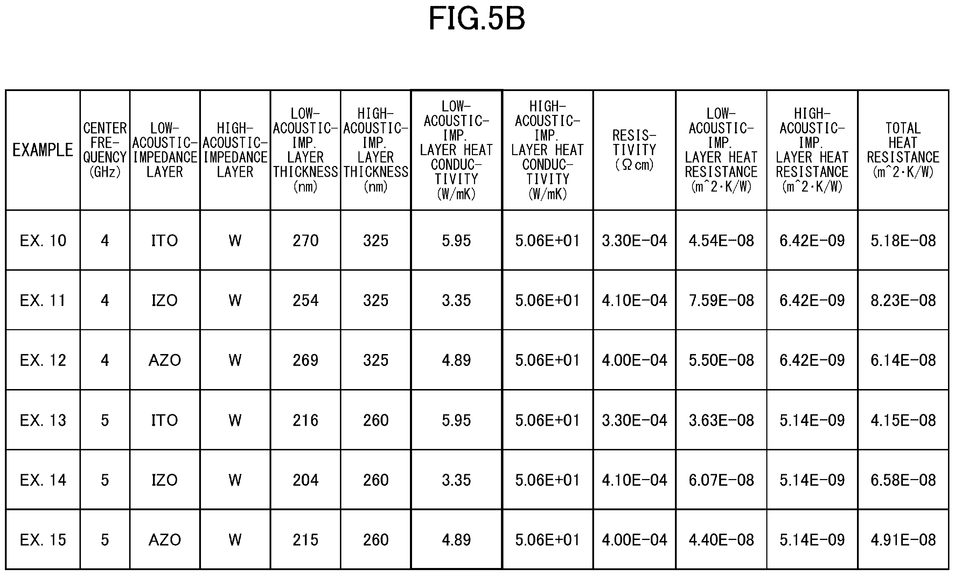

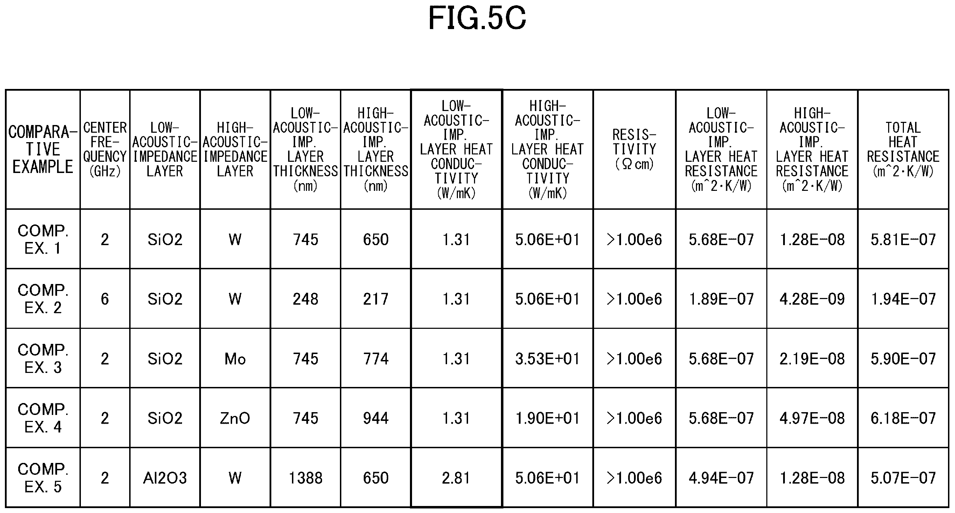

FIG. 5A and FIG. 5B indicate the configuration and thermal properties of the laminates of Examples. FIG. 5C indicates the configuration and thermal properties of the laminates of Comparative Examples. For the sake of illustration in FIG. 5A to FIG. 5C, the low-acoustic-impedance layer and the high-acoustic-impedance layer are represented as "low-acoustic-Imp. layer" and "high-acoustic-Imp. layer" in some fields, respectively. As a common configurational feature of Examples and Comparative Examples, three high-acoustic-impedance layers and as many low-acoustic-impedance layers are laminated alternately. The heat conductivity and the heat resistance of the low-acoustic-impedance layer and the high-acoustic-impedance layer are measured with changes made in the frequency of the high-frequency wave to be applied to the laminate, the thickness of the material of the low-acoustic-impedance layer, and the material and thickness of the high-acoustic-impedance layer. For the heat conductivity and the heat resistance, heat diffusibility $\lambda$ is calculated by a thermo-reflectance method and the heat conductivity $\kappa$ is calculated by the following formula.

$$\kappa \;=\; \rho c \lambda$$

$\rho$ represents density, and c represents a specific heat. The heat resistance R is calculated by the following formula.

$$R \;=\; d/\kappa$$

d represents film thickness.

<Example 1>

In Example 1, a silicon substrate was used as a substrate, and a high-acoustic-impedance layer was made of W, and a low-acoustic-impedance layer was made of ITO. In a case where the center frequency of the high-frequency wave to be applied is 2 GHz, the center wavelength of the acoustic wave that would propagate the high-acoustic-impedance layer would be approximately 2,600 nm. The thickness of the high-acoustic-impedance layer was set to 650 nm, which was 1/4 the center wavelength of the acoustic wave. The center wavelength of the acoustic wave that would propagate ITO of the low-acoustic-impedance layer would be approximately 2,165 nm, and the thickness of the ITO layer was set to 541 nm. ITO having a resistivity of $3.3 \times 10^{-4}$ S2cm had a sufficient electrical conductivity to cause heat conduction by carriers. Here, the heat conductivity of the high-acoustic-impedance layer was $5.06 \times 10$ (W/mK), and the heat conductivity of the low-acoustic-impedance layer was 5.95 (W/mk). The heat resistance of the low-acoustic-impedance layer was $9.08 \times 10^{-8}$ (m$^2$K/W), the heat resistance of the high-acoustic-impedance layer was $1.28 \times 10^{-8}$ (m$^2$K/W), and the total heat resistance was $1.04 \times 10^{-7}$ (m$^2$K/W). It can be seen that ITO had a very good heat conductivity, and that the acoustic multilayer film as a whole had a low heat resistance and a good heat conduction property.

<Example 2>

In Example 2, a silicon substrate was used as a substrate, and a high-acoustic-impedance layer was made of W, and a low-acoustic-impedance layer was made of IZO. The thickness of the high-acoustic-impedance layer was set to 650 nm as in Example 1. The center wavelength of the acoustic wave that would propagate IZO of the low-acoustic-impedance layer would be approximately 2,035 nm, and the thickness of the IZO layer was set to 509 nm. IZO having a resistivity of $4.1 \times 10^{-4}$ S2cm had a sufficient electrical conductivity to cause heat conduction by carriers. Here, the heat conductivity of the high-acoustic-impedance layer was $5.06 \times 10$ (W/mK), and the heat conductivity of the low-acoustic-impedance layer was 3.35 (W/mk). The heat resistance of the low-acoustic-impedance layer was $1.52 \times 10^{-7}$ (m$^2$K/W), the heat resistance of the high-acoustic-impedance layer was $1.28 \times 10^{-8}$ (m$^2$K/W), and the total heat resistance was $1.65 \times 10^{-7}$ (m$^2$K/W). The acoustic multilayer film as a whole had a low heat resistance and a good heat conduction property.

<Example 3>

In Example 3, a silicon substrate was used as a substrate, and a high-acoustic-impedance layer was made of W, and a low-acoustic-impedance layer was made of AZO. The thickness of the high-acoustic-impedance layer was set to 650 nm as in Example 1. The center wavelength of the acoustic wave that would propagate AZO of the low-acoustic-impedance layer would be approximately 2,052 nm, and the thickness of the AZO layer was set to 538 nm. AZO having a resistivity of $4.0 \times 10^{-4}$ S2cm had a sufficient electrical conductivity to cause heat conduction by carriers. Here, the heat conductivity of the high-acoustic-impedance layer was $5.06 \times 10$ (W/mK), and the heat conductivity of the low-acoustic-impedance layer was 4.89 (W/mk). The heat resistance of the low-acoustic-impedance layer was $1.10 \times 10^{-7}$ (m$^2$K/W), the heat resistance of the high-acoustic-impedance layer was $1.28 \times 10^{-8}$ (m$^2$K/W), and the total heat resistance was $1.23 \times 10^{-7}$ (m$^2$K/W). AZO had a good heat conductivity, and the acoustic multilayer film as a whole had a low heat resistance and a good heat conduction property.

<Example 4>

In Example 4, a high-acoustic-impedance layer was made of W, and a low-acoustic-impedance layer was made of ITO on a silicon substrate as in Example 1. Unlike in Example 1, the center frequency of the high-frequency wave to be applied was set to 6 GHz. In this case, the center wavelength of the acoustic wave that would propagate the high-acoustic-impedance layer would be approximately 868 nm, and the thickness of the high-acoustic-impedance layer was set to 217 nm. The center wavelength of the acoustic wave that would propagate the ITO layer would be approximately 720 nm, and the thickness of the ITO layer was set to 180 nm. ITO having a resistivity of $3.3\times10^\wedge-4$ S2cm had a sufficient electrical conductivity to cause heat conduction by carriers. Here, the heat conductivity of the high-acoustic-impedance layer was $5.06\times10$ (W/mK), and the heat conductivity of the low-acoustic-impedance layer was 5.95 (W/mk). The heat resistance of the low-acoustic-impedance layer was $3.03\times10^\wedge-8$ (m2K/W), the heat resistance of the high-acoustic-impedance layer was $4.28\times10^\wedge-9$ (m2K/W), and the total heat resistance was $3.64\times10^\wedge-8$ (m2K/W). ITO had a good heat conductivity, and the acoustic multilayer film as a whole had a low heat resistance in response to the 6-GHz resonant vibration and a good heat conduction property.

<Example 5>

In Example 5, a high-acoustic-impedance layer was made of W, and a low-acoustic-impedance layer was made of IZO on a silicon substrate as in Example 2. Unlike in Example 2, the center frequency of the high-frequency wave to be applied was set to 6 GHz. The thickness of the high-acoustic-impedance layer was set to 217 nm, and the thickness of the IZO layer was set to 170 nm. IZO having a resistivity of $4.1\times10^\wedge-4$ S2cm had a sufficient electrical conductivity to cause heat conduction by carriers. Here, the heat conductivity of the high-acoustic-impedance layer was $5.06\times10$ (W/mK), and the heat conductivity of the low-acoustic-impedance layer was 3.35 (W/mk). The heat resistance of the low-acoustic-impedance layer was $5.06\times10^\wedge-8$ (m2K/W), the heat resistance of the high-acoustic-impedance layer was $4.28\times10^\wedge-9$ (m2K/W), and the total heat resistance was $5.49\times10^\wedge-8$ (m2K/W). The acoustic multilayer film as a whole had a low heat resistance in response to the 6-GHz resonant vibration and a good heat conduction property.

<Example 6>

In Example 6, a high-acoustic-impedance layer was made of W, and a low-acoustic-impedance layer was made of AZO on a silicon substrate as in Example 3. Unlike in Example 3, the center frequency of the high-frequency wave to be applied was set to 6 GHz. The thickness of the high-acoustic-impedance layer was set to 217 nm, and the thickness of the AZO layer was set to 170 nm. AZO having a resistivity of $4.0\times10^\wedge-4$ S2cm had a sufficient electrical conductivity to cause heat conduction by carriers. Here, the heat conductivity of the high-acoustic-impedance layer was $5.06\times10$ (W/mK), and the heat conductivity of the low-acoustic-impedance layer was 4.89 (W/mk). The heat resistance of the low-acoustic-impedance layer was $3.47\times10^\wedge-8$ (m2K/W), the heat

resistance of the high-acoustic-impedance layer was $4.28\times10^\wedge-9$ (m2K/W), and the total heat resistance was $3.90\times10^\wedge-8$ (m2K/W). AZO had a good heat conductivity, and the acoustic multilayer film as a whole had a low heat resistance in response to the 6-GHz resonant vibration and a good heat conduction property.

<Example 7>

In Example 7, a high-acoustic-impedance layer was made of W, and a low-acoustic-impedance layer was made of ITO on a silicon substrate as in Example 1. Unlike in Example 1, the center frequency of the high-frequency wave to be applied was set to 3 GHz. The thickness of the high-acoustic-impedance layer was set to 433 nm. The thickness of the low-acoustic-impedance (ITO) was set to 360 nm. The materials of the low-acoustic-impedance layer and the high-acoustic-impedance layer were ITO and W, respectively, as in Example 1, and had the same heat conductivities as in Example 1, respectively. The heat resistance of the low-acoustic-impedance layer was $6.06\times10^\wedge-8$ (m2K/W), the heat resistance of the high-acoustic-impedance layer was $8.56\times10^\wedge-9$ (m2K/W), and the total heat resistance was $6.91\times10^\wedge-8$ (m2K/W). ITO had a good heat conductivity, and the acoustic multilayer film as a whole had a low heat resistance in response to the 6-GHz resonant vibration and a good heat conduction property.

<Example 8>

In Example 8, a high-acoustic-impedance layer was made of W, and a low-acoustic-impedance layer was made of IZO on a silicon substrate as in Example 2. Unlike in Example 2, the center frequency of the high-frequency wave to be applied was set to 3 GHz. The thickness of the high-acoustic-impedance layer was set to 433 nm, and the thickness of the IZO layer was set to 339 nm. The materials of the low-acoustic-impedance layer and the high-acoustic-impedance layer were IZO and W, respectively, as in Example 2, and had the same heat conductivities as in Example 2, respectively. The heat resistance of the low-acoustic-impedance layer was $1.01\times10^\wedge-7$ (m2K/W), the heat resistance of the high-acoustic-impedance layer was $8.56\times10^\wedge-9$ (m2K/W), and the total heat resistance was $1.10\times10^\wedge-7$ (m2K/W). The acoustic multilayer film as a whole had a low heat resistance in response to the 3-GHz resonant vibration and a good heat conduction property.

<Example 9>

In Example 9, a high-acoustic-impedance layer was made of W, and a low-acoustic-impedance layer was made of AZO on a silicon substrate as in Example 3. Unlike in Example 3, the center frequency of the high-frequency wave to be applied was set to 3 GHz. The thickness of the high-acoustic-impedance layer was set to 433 nm, and the thickness of the AZO layer was set to 358 nm. The materials of the low-acoustic-impedance layer and the high-acoustic-impedance layer were AZO and W, respectively, as in Example 3, and had the same heat conductivities as in Example 3, respectively. The heat resistance of the low-acoustic-impedance layer was $7.33 \times 10^{-8}$ ($m^2K/W$), the heat resistance of the high-acoustic-impedance layer was $8.56 \times 10^{-9}$ ($m^2K/W$), and the total heat resistance was $8.18 \times 10^{-8}$ ($m^2K/W$). AZO had a good heat conductivity, and the acoustic multilayer film as a whole had a low heat resistance in response to the 3-GHz resonant vibration and a good heat conduction property.

<Example 10>

In Example 10, a high-acoustic-impedance layer was made of W, and a low-acoustic-impedance layer was made of ITO on a silicon substrate as in Example 1. Unlike in Example 1, the center frequency of the high-frequency wave to be applied was set to 4 GHz. The thickness of the high-acoustic-impedance layer was set to 325 nm. The thickness of the low-acoustic-impedance (ITO) was set to 270 nm. The materials of the low-acoustic-impedance layer and the high-acoustic-impedance layer were ITO and W, respectively, as in Example 1, and had the same heat conductivities as in Example 1, respectively. The heat resistance of the low-acoustic-impedance layer was $4.54 \times 10^{-8}$ ($m^2K/W$), the heat resistance of the high-acoustic-impedance layer was $6.42 \times 10^{-9}$ ($m^2K/W$), and the total heat resistance was $5.18 \times 10^{-8}$ ($m^2K/W$). ITO had a good heat conductivity, and the acoustic multilayer film as a whole had a low heat resistance in response to the 4-GHz resonant vibration and a good heat conduction property.

<Example 11>

In Example 8, a high-acoustic-impedance layer was made of W, and a low-acoustic-impedance layer was made of IZO on a silicon substrate as in Example 2. Unlike in Example 2, the center frequency of the high-frequency wave to be applied was set to 4 GHz. The thickness of the high-acoustic-impedance layer was set to 325 nm, and the thickness of the IZO layer was set to 254 nm. The materials of the low-acoustic-impedance layer and the high-acoustic-impedance layer were IZO and W, respectively, as in Example 2, and had the same heat conductivities as in Example 2, respectively. The heat resistance of the low-acoustic-impedance layer was $7.58 \times 10^{-8}$ ($m^2K/W$), the heat resistance of the high-acoustic-impedance layer was $6.42 \times 10^{-9}$ ($m^2K/W$), and the total heat resistance was $8.23 \times 10^{-8}$ ($m^2K/W$). The acoustic multilayer film as a whole had a low heat resistance in response to the 4-GHz resonant vibration and a good heat conduction property.

<Example 12>

In Example 12, a high-acoustic-impedance layer was made of W, and a low-acoustic-impedance layer was made of AZO on a silicon substrate as in Example 3. Unlike in Example 3, the center frequency of the high-frequency wave to be applied was set to 4 GHz. The thickness of the high-acoustic-impedance layer was set to 325 nm, and the thickness of the AZO layer was set to 269 nm. The materials of the low-acoustic-impedance layer and the high-acoustic-impedance layer were AZO and W, respectively, as in Example 3, and had the same heat conductivities as in Example 3, respectively. The heat resistance of the low-acoustic-impedance layer was $5.50 \times 10^{-8}$ ($m^2K/W$), the heat resistance of the high-acoustic-impedance layer was $6.42 \times 10^{-9}$ ($m^2K/W$), and the total heat resistance was $6.14 \times 10^{-8}$ ($m^2K/W$). AZO had a good heat conductivity, and the acoustic multilayer film as a whole had a low heat resistance in response to the 4-GHz resonant vibration and a good heat conduction property.

<Example 13>

In Example 13, a high-acoustic-impedance layer was made of W, and a low-acoustic-impedance layer was made of ITO on a silicon substrate as in Example 1. Unlike in Example 1, the center frequency of the high-frequency wave to be applied was set to 5 GHz. The thickness of the high-acoustic-impedance layer was set to 260 nm. The thickness of the low-acoustic-impedance (ITO) was set to 216 nm. The materials of the low-acoustic-impedance layer and the high-acoustic-impedance layer were ITO and W, respectively, as in Example 1, and had the same heat conductivities as in Example 1, respectively. The heat resistance of the low-acoustic-impedance layer was $3.63 \times 10^{-8}$ ($m^2K/W$), the heat resistance of the high-acoustic-impedance layer was $5.14 \times 10^{-9}$ ($m^2K/W$), and the total heat resistance was $4.15 \times 10^{-8}$ ($m^2K/W$). ITO had a good heat conductivity, and the acoustic multilayer film as a whole had a low heat resistance in response to the 5-GHz resonant vibration and a good heat conduction property.

<Example 14>

In Example 14, a high-acoustic-impedance layer was made of W, and a low-acoustic-impedance layer was made of IZO on a silicon substrate as in Example 2. Unlike in Example 2, the center frequency of the high-frequency wave to be applied was set to 5 GHz. The thickness of the high-acoustic-impedance layer was set to 260 nm, and the thickness of the IZO layer was set to 204 nm. The materials of the low-acoustic-impedance layer and the high-acoustic-impedance layer were IZO and W, respectively, as in Example 2, and had the same heat conductivities as in Example 2, respectively. The heat resistance of the low-acoustic-impedance layer was

$6.07 \times 10^{-8}$ ($m^2$K/W), the heat resistance of the high-acoustic-impedance layer was $5.14 \times 10^{-9}$ ($m^2$K/W), and the total heat resistance was $6.58 \times 10^{-8}$ ($m^2$K/W). The acoustic multilayer film as a whole had a low heat resistance in response to the 5-GHz resonant vibration and a good heat conduction property.

<Example 15>

In Example 15, a high-acoustic-impedance layer was made of W, and a low-acoustic-impedance layer was made of AZO on a silicon substrate as in Example 3. Unlike in Example 3, the center frequency of the high-frequency wave to be applied was set to 5 GHz. The thickness of the high-acoustic-impedance layer was set to 260 nm, and the thickness of the AZO layer was set to 215 nm. The materials of the low-acoustic-impedance layer and the high-acoustic-impedance layer were AZO and W, respectively, as in Example 3, and had the same heat conductivities as in Example 3, respectively. The heat resistance of the low-acoustic-impedance layer was $4.40 \times 10^{-8}$ ($m^2$K/W), the heat resistance of the high-acoustic-impedance layer was $5.14 \times 10^{-9}$ ($m^2$K/W), and the total heat resistance was $4.91 \times 10^{-8}$ ($m^2$K/W). AZO had a good heat conductivity, and the acoustic multilayer film as a whole had a low heat resistance in response to the 4-GHz resonant vibration and a good heat conduction property.

<Comparative Example 1>

Referring to FIG. 5C, in Comparative Example 1, a silicon substrate was used as a substrate, and a high-acoustic-impedance layer was made of W, and a low-acoustic-impedance layer was made of $SiO_2$. In a case of the center frequency of the high-frequency wave to be applied being 2 GHz, the thickness of the high-acoustic-impedance layer was set to 650 nm. The center wavelength of the acoustic wave that would propagate $SiO_2$ serving as the low-acoustic-impedance layer would be approximately 2,980 nm, and the thickness of the $SiO_2$ layer was set to 745 nm. $SiO_2$, which is an insulating material in general and has a resistivity of 10^6 S2cm or higher, would not cause heat conduction by carriers. Here, the heat conductivity of the high-acoustic-impedance layer was $5.06 \times 10$ (W/mK), and the heat conductivity of the low-acoustic-impedance layer was 1.31 (W/mk), which was low. The heat resistance of the high-acoustic-impedance layer was $1.28 \times 10^{-8}$ ($m^2$K/W) whereas the heat resistance of the low-acoustic-impedance layer was $5.68 \times 10^{-7}$ ($m^2$K/W), which was high, resulting in a high total heat resistance of $5.81 \times 10^{-7}$ ($m^2$K/W). Because $SiO_2$ had a poor heat resistivity and a high heat resistance, the acoustic multilayer film as a whole had a high heat resistance and a poor heat conduction property. Because this acoustic multilayer film could not dissipate heat sufficiently, there was a risk that the resonance property would degrade.

<Comparative Example 2>

In Comparative Example 2, a high-acoustic-impedance layer was made of W, and a low-acoustic-impedance layer was made of $SiO_2$ on a silicon substrate as in Comparative Example 1. However, a high-frequency wave having a center frequency of 6 GHz was applied. The thickness of the high-acoustic-impedance layer was set to 217 nm, and the thickness of the $SiO_2$ layer, which was the low-acoustic-impedance layer, was set to 248 nm. $SiO_2$, which is an insulating material in general and has a resistivity of 10^6 S2cm or higher, would not cause heat conduction by carriers. Here, the heat conductivity of the high-acoustic-impedance layer was $5.06 \times 10$ (W/mK), and the heat conductivity of the low-acoustic-impedance layer was 1.31 (W/mk), which was low. The heat resistance of the high-acoustic-impedance layer was $4.28 \times 10^{-9}$ ($m^2$K/W) whereas the heat resistance of the low-acoustic-impedance layer was $1.89 \times 10^{-7}$ ($m^2$K/W), which was high, resulting in a high total heat resistance of $1.94 \times 10^{-7}$ ($m^2$K/W). Because $SiO_2$ had a poor heat resistivity and a high heat resistance, the acoustic multilayer film as a whole had a high heat resistance as well. This acoustic multilayer film could not dissipate heat sufficiently in response to the 6-GHz resonant vibration, and there was a risk that the resonance property would degrade.

<Comparative Example 3>

In Comparative Example 3, a silicon substrate was used as a substrate, a high-acoustic-impedance layer was made of Mo, a low-acoustic-impedance layer was made of $SiO_2$, and a high-frequency wave having a center frequency of 2 GHz was applied. The center wavelength of the acoustic wave that would propagate Mo would be approximately 3,096 nm, and the thickness of the Mo layer was set to 774 nm. The thickness of the $SiO_2$ low-acoustic-impedance layer was set to 745 nm as in Comparative Example 1. $SiO_2$, which is an insulating material in general and has a resistivity of 10^6 S2cm or higher, would not cause heat conduction by carriers. Here, the heat conductivity of the high-acoustic-impedance layer was $3.53 \times 10$ (W/mK), which was sufficiently high, whereas the heat conductivity of the low-acoustic-impedance layer was 1.31 (W/mk), which was low. The heat resistance of the high-acoustic-impedance layer was $2.19 \times 10^{-8}$ ($m^2$K/W) whereas the heat resistance of the low-acoustic-impedance layer was $5.68 \times 10^{-7}$ ($m^2$K/W), which was high, resulting in a high total heat resistance of $5.90 \times 10^{-7}$ ($m^2$K/W). Because $SiO_2$ had a poor heat resistivity and a high heat resistance, the acoustic multilayer film as a whole had a high heat resistance as well. This acoustic multilayer film could not dissipate heat sufficiently in response to the 2-GHz resonant vibration, and there was a risk that the resonance property would degrade.

<Comparative Example 4>

In Comparative Example 4, a silicon substrate was used as a substrate, a high-acoustic-impedance layer was made of ZnO, a low-acoustic-impedance layer was made of $SiO_2$, and a high-frequency wave having a center frequency of 2 GHz was applied. The center wavelength of the acoustic wave that would propagate ZnO would be approximately 3,776 nm, and the thickness of the ZnO layer was set to 944 nm. The thickness of the $SiO_2$ low-acoustic-impedance layer was set to 745 nm as in Comparative Examples 1 and 3. $SiO_2$, which is an insulating material in general and has a resistivity of $10^6$ S2cm or higher, would not cause heat conduction by carriers. Here, the heat conductivity of the high-acoustic-impedance layer was $1.94 \times 10$ (W/mK), and the heat conductivity of the low-acoustic-impedance layer was 1.31 (W/mk). The heat resistance of the high-acoustic-impedance layer was $4.97 \times 10^{-8}$ ($m^2$K/W) whereas the heat resistance of the low-acoustic-impedance layer was $5.68 \times 10^{-7}$ ($m^2$K/W), which was high, resulting in a high total heat resistance of $6.18 \times 10^{-7}$ ($m^2$K/W). Because $SiO_2$ had a poor heat resistivity and a high heat resistance, the acoustic multilayer film as a whole had a high heat resistance as well. This acoustic multilayer film could not dissipate heat sufficiently in response to the 2-GHz resonant vibration, and there was a risk that the resonance property would degrade.

<Comparative Example 5>

In Comparative Example 5, a silicon substrate was used as a substrate, a high-acoustic-impedance layer was made of W, a low-acoustic-impedance layer was made of $Al_2O_3$, and a high-frequency wave having a center frequency of 2 GHz was applied. The thickness of the W layer was set to 650 nm as in Comparative Example 1. The center wavelength of the acoustic wave that would propagate $Al_2O_3$ would be approximately 5,552 nm, and the thickness of the low-acoustic-impedance layer was set to 1,388 nm. $Al_2O_3$, which is an insulating material in general and has a resistivity of 10^6 S2cm or higher, would not cause heat conduction by carriers. Here, the heat conductivity of the high-acoustic-impedance layer was $5.06 \times 10$ (W/mK), and the heat conductivity of the low-acoustic-impedance layer was 2.81 (W/mk), which was a bit high, when compared with $SiO_2$. The heat resistance of the high-acoustic-impedance layer was $1.28 \times 10^{-8}$ ($m^2$K/W) whereas the heat resistance of the low-acoustic-impedance layer was $4.94 \times 10^{-7}$ ($m^2$K/W), which was high, resulting in a high total heat resistance of $5.07 \times 10^{-7}$ ($m^2$K/W). $Al_2O_3$ would conduct heat predominantly by phonons, and had a high heat resistance. The acoustic multilayer film as a whole could not dissipate heat sufficiently in response to the 2-GHz resonant vibration, and there was a risk that the resonance property would degrade.

Based on Examples 1 to 15 and Comparative Examples 1 to 5, it can be seen that formation of the low-acoustic-impedance layer made of an electrically-conductive oxide such as ITO, IZO, AZO, or the like instead of an insulating layer such as $SiO_2$, $Al_2O_3$, or the like leads to heat conduction by carriers, and to improvement of the heat conductivity. Electrically-conductive oxides other than ITO, IZO, and AZO, such as FTO, GZO, ATO, PTO, and the like may also be used, and a complex of one or more electrically-conductive oxides may also be used. By using an electrically-conductive oxide having a resistivity of $1.0 \times 10^{-3}$ S2cm or lower as the low-acoustic-impedance layer, it is possible to maintain the heat conductivity through the low-acoustic-impedance layer to 3 W/mK or higher and to improve the heat dissipation property of the acoustic multilayer film as a whole.

The present invention has been described above based on specific Examples. However, the present invention is not limited to the configuration examples described above. For example, the high-acoustic-impedance layer may be made of not only W, Mo, or ZnO, but also $Ta_2O_5$, Ru, or Ir, or a complex of these, and the low-acoustic-impedance layer may be made of a transparent electrode material. The uppermost low-acoustic-impedance layer of the acoustic multilayer film may be made of an insulating layer such as $SiO_2$, $Al_2O_3$, and the like. As long as heat conduction by carriers is predominantly achieved by low-acoustic-impedance layers made of an oxide conductor as a whole, some other low-acoustic-impedance layers may be made of an insulating layer in addition to the uppermost low-acoustic-impedance layer. In any case, the heat conductivity of the acoustic multilayer film as a whole is improved. When an active element such as a resonator, a piezoelectric element, or the like is connected to the acoustic multilayer film, heat generated by the active element can be efficiently dissipated to the support substrate via the acoustic multilayer film. In the laminate of the embodiment, the low-acoustic-impedance layers can diffuse heat by carriers, and a high heat dissipation property is realized without the need for a complicated processing. The device operation reliability of a high-frequency filter device using the laminate is improved because property degradation of the acoustic multilayer film due to heat generated by the active element is inhibited.

The present application claims priority to Japanese Patent Application No. 2022-058815 filed with the Japan Patent Office on March 31, 2022, the entire contents of which are incorporated herein by reference.

REFERENCE SIGNS LIST

   10, 30 bulk acoustic wave filter device
   11 support substrate
   12 first electrode layer
   13 piezoelectric layer
   14 second electrode layer

15 resonator (active element)
16, 26 high-acoustic-impedance layer (first layer)
17, 27-1, 27-2 low-acoustic-impedance layer (second layer)
18, 28 acoustic multilayer film
19 insulating layer
20, 40 laminate

**Claims**

1.  A bulk acoustic wave filter device, comprising:

    an acoustic multilayer film on a support substrate, a first layer having a predetermined specific acoustic impedance and a second layer having a specific acoustic impedance lower than that of the first layer being alternately laminated in the acoustic multilayer film; and
    an active element provided on a side of the acoustic multilayer film opposite to the support substrate,
    wherein the active element includes a first electrode layer provided over the acoustic multilayer film, a piezoelectric layer provided on the first electrode layer, and a second electrode layer provided on the piezoelectric layer,
    one or more, or all of second layers, each being the second layer, in the acoustic multilayer film have an electrical conductivity, and
    an insulating layer is provided between the acoustic multilayer film and the first electrode layer.

2.  The bulk acoustic wave filter device according to claim 1,
    wherein the second layer that has the electrical conductivity has an electrical resistivity of $1.0 \times 10^{-3}$ S2cm or lower.

3.  The bulk acoustic wave filter device according to claim 1 or 2,
    wherein the second layer that has the electrical conductivity has a heat conductivity of 3 W/mK or higher.

4.  The bulk acoustic wave filter device according to any one of claims 1 to 3,
    wherein the second layer that has the electrical conductivity is made of an electrically-conductive oxide or a transparent electrode material.

5.  The bulk acoustic wave filter device according to claim 4,
    wherein the second layer that has the electrical conductivity is ITO, AZO, IZO, FTO, GZO, ATO, or PTO, or a complex of these.

6.  The bulk acoustic wave filter device according to any one of claims 1 to 5,
    wherein the first layer is W, Mo, $Ta_2O_5$, ZnO, Ru, or Ir, or a complex of these.

7.  The bulk acoustic wave filter device according to any one of claims 1 to 6,
    wherein the second layer that is provided as an uppermost layer of the acoustic multilayer film has an insulating property.

8.  The bulk acoustic wave filter device according to claim 1,

    wherein all of second layers, each being the second layer, have the electrical conductivity, and
    the bulk acoustic wave filter device further comprises an insulating layer provided on the acoustic multilayer film.

# FIG.1

# FIG.2

<u>10</u>

# FIG.3

# FIG.4

# FIG.5A

| EXAMPLE | CENTER FRE-QUENCY (GHz) | LOW-ACOUSTIC-IMPEDANCE LAYER | HIGH-ACOUSTIC-IMPEDANCE LAYER | LOW-ACOUSTIC-IMP. LAYER THICKNESS (nm) | HIGH-ACOUSTIC-IMP. LAYER THICKNESS (nm) | LOW-ACOUSTIC-IMP. LAYER HEAT CONDUC-TIVITY (W/mK) | HIGH-ACOUSTIC-IMP. LAYER HEAT CONDUC-TIVITY (W/mK) | RESIS-TIVITY ($\Omega$ cm) | LOW-ACOUSTIC-IMP. LAYER HEAT RESISTANCE (m^2·K/W) | HIGH-ACOUSTIC-IMP. LAYER HEAT RESISTANCE (m^2·K/W) | TOTAL HEAT RESISTANCE (m^2·K/W) |
|---|---|---|---|---|---|---|---|---|---|---|---|
| EX. 1 | 2 | ITO | W | 541 | 650 | 5.95 | 5.06E+01 | 3.30E-04 | 9.08E-08 | 1.28E-08 | 1.04E-07 |
| EX. 2 | 2 | IZO | W | 509 | 650 | 3.35 | 5.06E+01 | 4.10E-04 | 1.52E-07 | 1.28E-08 | 1.65E-07 |
| EX. 3 | 2 | AZO | W | 538 | 650 | 4.89 | 5.06E+01 | 4.00E-04 | 1.10E-07 | 1.28E-08 | 1.23E-07 |
| EX. 4 | 6 | ITO | W | 180 | 217 | 5.95 | 5.06E+01 | 3.30E-04 | 3.03E-08 | 4.28E-09 | 3.46E-08 |
| EX. 5 | 6 | IZO | W | 170 | 217 | 3.35 | 5.06E+01 | 4.10E-04 | 5.06E-08 | 4.28E-09 | 5.49E-08 |
| EX. 6 | 6 | AZO | W | 170 | 217 | 4.89 | 5.06E+01 | 4.00E-04 | 3.47E-08 | 4.28E-09 | 3.90E-08 |
| EX. 7 | 3 | ITO | W | 360 | 433 | 5.95 | 5.06E+01 | 3.30E-04 | 6.06E-08 | 8.56E-09 | 6.91E-08 |
| EX. 8 | 3 | IZO | W | 339 | 433 | 3.35 | 5.06E+01 | 4.10E-04 | 1.01E-07 | 8.56E-09 | 1.10E-07 |
| EX. 9 | 3 | AZO | W | 358 | 433 | 4.89 | 5.06E+01 | 4.00E-04 | 7.33E-08 | 8.56E-09 | 8.18E-08 |

# FIG.5B

| EXAMPLE | CENTER FRE-QUENCY (GHz) | LOW-ACOUSTIC-IMPEDANCE LAYER | HIGH-ACOUSTIC-IMPEDANCE LAYER | LOW-ACOUSTIC-IMP. LAYER THICKNESS (nm) | HIGH-ACOUSTIC-IMP. LAYER THICKNESS (nm) | LOW-ACOUSTIC-IMP. LAYER HEAT CONDUC-TIVITY (W/mK) | HIGH-ACOUSTIC-IMP. LAYER HEAT CONDUC-TIVITY (W/mK) | RESIS-TIVITY ($\Omega$cm) | LOW-ACOUSTIC-IMP. LAYER HEAT RESISTANCE (m^2·K/W) | HIGH-ACOUSTIC-IMP. LAYER HEAT RESISTANCE (m^2·K/W) | TOTAL HEAT RESISTANCE (m^2·K/W) |
|---|---|---|---|---|---|---|---|---|---|---|---|
| EX. 10 | 4 | ITO | W | 270 | 325 | 5.95 | 5.06E+01 | 3.30E-04 | 4.54E-08 | 6.42E-09 | 5.18E-08 |
| EX. 11 | 4 | IZO | W | 254 | 325 | 3.35 | 5.06E+01 | 4.10E-04 | 7.59E-08 | 6.42E-09 | 8.23E-08 |
| EX. 12 | 4 | AZO | W | 269 | 325 | 4.89 | 5.06E+01 | 4.00E-04 | 5.50E-08 | 6.42E-09 | 6.14E-08 |
| EX. 13 | 5 | ITO | W | 216 | 260 | 5.95 | 5.06E+01 | 3.30E-04 | 3.63E-08 | 5.14E-09 | 4.15E-08 |
| EX. 14 | 5 | IZO | W | 204 | 260 | 3.35 | 5.06E+01 | 4.10E-04 | 6.07E-08 | 5.14E-09 | 6.58E-08 |
| EX. 15 | 5 | AZO | W | 215 | 260 | 4.89 | 5.06E+01 | 4.00E-04 | 4.40E-08 | 5.14E-09 | 4.91E-08 |

# FIG.5C

| COMPARA-TIVE EXAMPLE | CENTER FRE-QUENCY (GHz) | LOW-ACOUSTIC-IMPEDANCE LAYER | HIGH-ACOUSTIC-IMPEDANCE LAYER | LOW-ACOUSTIC-IMP. LAYER THICKNESS (nm) | HIGH-ACOUSTIC-IMP. LAYER THICKNESS (nm) | LOW-ACOUSTIC-IMP. LAYER HEAT CONDUC-TIVITY (W/mK) | HIGH-ACOUSTIC-IMP. LAYER HEAT CONDUC-TIVITY (W/mK) | RESIS-TIVITY (Ω cm) | LOW-ACOUSTIC-IMP. LAYER HEAT RESISTANCE (m^2·K/W) | HIGH-ACOUSTIC-IMP. LAYER HEAT RESISTANCE (m^2·K/W) | TOTAL HEAT RESISTANCE (m^2·K/W) |
|---|---|---|---|---|---|---|---|---|---|---|---|
| COMP. EX. 1 | 2 | SiO2 | W | 745 | 650 | 1.31 | 5.06E+01 | >1.00e6 | 5.68E-07 | 1.28E-08 | 5.81E-07 |
| COMP. EX. 2 | 6 | SiO2 | W | 248 | 217 | 1.31 | 5.06E+01 | >1.00e6 | 1.89E-07 | 4.28E-09 | 1.94E-07 |
| COMP. EX. 3 | 2 | SiO2 | Mo | 745 | 774 | 1.31 | 3.53E+01 | >1.00e6 | 5.68E-07 | 2.19E-08 | 5.90E-07 |
| COMP. EX. 4 | 2 | SiO2 | ZnO | 745 | 944 | 1.31 | 1.90E+01 | >1.00e6 | 5.68E-07 | 4.97E-08 | 6.18E-07 |
| COMP. EX. 5 | 2 | Al2O3 | W | 1388 | 650 | 2.81 | 5.06E+01 | >1.00e6 | 4.94E-07 | 1.28E-08 | 5.07E-07 |

## INTERNATIONAL SEARCH REPORT

International application No.

**PCT/JP2023/012773**

### A.    CLASSIFICATION OF SUBJECT MATTER

*H03H 9/17*(2006.01)i
FI:    H03H9/17 F

According to International Patent Classification (IPC) or to both national classification and IPC

### B.    FIELDS SEARCHED

Minimum documentation searched (classification system followed by classification symbols)

H03H9/17

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C.    DOCUMENTS CONSIDERED TO BE RELEVANT

| Category* | Citation of document, with indication, where appropriate, of the relevant passages | Relevant to claim No. |
|---|---|---|
| X | JP 2005-136761 A (TDK CORP.) 26 May 2005 (2005-05-26)<br>paragraphs [0021]-[0034], fig. 1 | 1-3, 6, 8 |
| A | | 4-5 |
| X | JP 2020-113954 A (MURATA MANUFACTURING CO., LTD.) 27 July 2020 (2020-07-27)<br>paragraphs [0011]-[0028], fig. 1 | 1-3, 6-7 |
| A | | 4-5 |
| A | JP 2008-34925 A (MATSUSHITA ELECTRIC INDUSTRIAL CO., LTD.) 14 February 2008 (2008-02-14)<br>paragraphs [0035]-[0046], fig. 2 | 1-8 |

☐ Further documents are listed in the continuation of Box C.        ☑ See patent family annex.

| | |
|---|---|
| *    Special categories of cited documents: | "T"    later document published after the international filing date or priority date and not in conflict with the application but cited to understand the principle or theory underlying the invention |
| "A"    document defining the general state of the art which is not considered to be of particular relevance | |
| "E"    earlier application or patent but published on or after the international filing date | "X"    document of particular relevance; the claimed invention cannot be considered novel or cannot be considered to involve an inventive step when the document is taken alone |
| "L"    document which may throw doubts on priority claim(s) or which is cited to establish the publication date of another citation or other special reason (as specified) | "Y"    document of particular relevance; the claimed invention cannot be considered to involve an inventive step when the document is combined with one or more other such documents, such combination being obvious to a person skilled in the art |
| "O"    document referring to an oral disclosure, use, exhibition or other means | |
| "P"    document published prior to the international filing date but later than the priority date claimed | "&"    document member of the same patent family |

| Date of the actual completion of the international search | Date of mailing of the international search report |
|---|---|
| **07 June 2023** | **20 June 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2023/012773**

| Patent document cited in search report | | | Publication date (day/month/year) | Patent family member(s) | Publication date (day/month/year) |
|---|---|---|---|---|---|
| JP | 2005-136761 | A | 26 May 2005 | (Family: none) | |
| JP | 2020-113954 | A | 27 July 2020 | US 2020/0228092 A1 paragraphs [0016]-[0032], fig. 1 CN 111446942 A | |
| JP | 2008-34925 | A | 14 February 2008 | US 2007/0279155 A1 paragraphs [0079]-[0090], fig. 9 | |

Form PCT/ISA/210 (patent family annex) (January 2015)

**EP 4 503 435 A1**

**REFERENCES CITED IN THE DESCRIPTION**

**Patent documents cited in the description**

- JP 6668347 B

- JP 2022058815 A